# FASCICULE DE BREVET EUROPEEN

(11) **EP 2 680 303 B1**
(45) Date de publication et mention de la délivrance du brevet: **09.10.2019**
(21) Numéro de dépôt: 13173615.9
(22) Date de dépôt: 25.06.2013
(51) Int. Cl.: H01L 23/15, H01L 23/373, C04B 35/5831, C04B 35/581

(54) **Circuit électrique susceptible d'être connecté directement à de la haute tension**
Schaltkeis zum direkten Anschluss an Hochspannung
Electric circuit suitable for direct connection to high voltage

(30) Priorité: 25.06.2012 FR 1256014
(43) Date de publication de la demande: 01.01.2014
(73) Titulaire: ALSTOM Transport Technologies, 93400 Saint-Ouen (FR)
(72) Inventeur: Dagdag, Selim, 65000 TARBES (FR); Barry, John James, ENNIS (IE); Sandström, Leif Anders, SE-91523 Robertsfors (SE)
(74) Mandataire: Lavoix

(56) Documents cités:
- EP-A1- 1 528 048
- EP-A2- 0 308 873
- EP-A2- 0 450 968
- WO-A2-00/08686
- US-A- 5 457 075

## Description

La présente invention concerne un circuit électrique susceptible d'être connecté directement à de la haute tension. Elle se rapporte également à un dispositif électrique comportant un tel circuit et au procédé de fabrication du circuit.

Une chaîne de traction de véhicule ferroviaire comporte des éléments de conversion d'énergie électrique, des dispositifs de transport d'énergie électrique et des éléments de conversion d'énergie électrique en énergie mécanique de type moteur de traction solidaire d'un axe de rotation entraînant une des roues du véhicule. Le moteur est fixé sur le bogie.

La chaîne comporte ainsi usuellement une pluralité de convertisseurs servant à transformer les signaux électriques que ce soit de type continu (aussi désigné par l'acronyme DC) en type alternatif (aussi désigné par l'acronyme AC) ou l'inverse, soit de type continu en type continu ou encore de type alternatif en type alternatif. Parmi ces convertisseurs, un onduleur est alimenté par une tension continue typiquement comprise entre 750 V (Volts) et 3300 V. Typiquement, l'alimentation en tension continue provient d'un pont redresseur simple ou de type PMCF (acronyme pour Pont Monophasé à Commutation Forcée) ayant transformé une tension de type alternative préalablement abaissée depuis la tension caténaire à l'aide d'un transformateur.

A partir de cette alimentation en tension continue, l'onduleur délivre trois phases d'un courant alternatif triphasé au moteur de traction. Ces trois phases sont créées en prenant le point milieu de deux interrupteurs de puissance mis en série et connectés au potentiel continu.

Les interrupteurs de puissance qui composent l'onduleur se présentent chacun sous la forme d'un boîtier de protection comportant un circuit électrique assurant la fonction d'interrupteur. L'ensemble du boîtier et de son contenu (module de puissance) est parfois appelé sous le terme anglais « pack ». Cet ensemble sera appelé sous le terme de « dispositif électrique » dans le reste de la description.

Le circuit électrique d'un interrupteur de puissance comporte généralement une pluralité de circuits électriques et de circuits intégrés reliés électriquement, ces circuits intégrés étant supportés indirectement par des substrats isolants dont le routage correspond à un circuit électrique.

Le document WO 00/08686 décrit un substrat pour des modules haute tension.

Les substrats isolants ont pour fonction d'assurer l'isolation électrique entre le ou les circuits intégrés qu'ils supportent et la face arrière du boîtier, d'évacuer les pertes créées par échauffement des circuits intégrés et d'éviter d'imposer des contraintes thermomécaniques fortes à l'assemblage qui supporte les circuits intégrés. Les circuits intégrés sont par exemple des transistors bipolaires à grilles isolées (usuellement appelés sous l'acronyme IGBT qui désigne en anglais « insulated gate bipolar transistor ») ou des transistors à effets de champ (JFET pour « junction field effect transistor » ou MOSFET pour « metal oxyde semi-conductor field transistor »), ou des diodes.

L'une des manières de diminuer le poids de la chaîne de traction embarquée dans le véhicule ferroviaire repose sur l'augmentation des fréquences de commutation du signal à traiter par le transformateur. Cela permet, en effet, de diminuer fortement la taille du transformateur qui est inversement proportionnelle à la fréquence de ce signal. Ainsi, dans une architecture classique avec le transformateur en tête de la chaîne de traction, la fréquence de la tension caténaire étant comprise entre 10 Hz (Hertz) et 60 Hz, la taille et le poids du transformateur sont très élevés.

Cette transformation électrique du signal de la caténaire basse fréquence (10 à 60 Hz) en un signal électrique à fréquence plus élevée (quelques kHz) est réalisée grâce à des convertisseurs de puissances directement connectés à la caténaire. Ainsi, un signal de fréquence de quelques kHz peut être injecté en entrée du transformateur ou des transformateurs dans le cas d'une structure multi étage à multi transformateur en parallèle.

La contrepartie de la diminution de la taille du transformateur est le déplacement du transformateur depuis la caténaire vers le milieu de la chaîne de traction. Ainsi l'architecture de la chaîne de traction est modifiée depuis l'architecture classique avec transformateur / convertisseurs / moteur à une architecture de type convertisseur / transformateur / convertisseur / moteur. Cela implique de positionner des convertisseurs de puissance en tête de la chaîne de traction au plus proche de la caténaire et notamment d'exposer de manière continue certains composants du convertisseur à des différences de potentiel plus importantes.

Les interrupteurs de puissance de tête mis en série servent alors de pont diviseur de tension dans une telle configuration puisqu'une tension pouvant être comprise entre 750 V (Volts) et 3300 V est imposée à leur borne.

Ainsi, en présence d'un transformateur en tête, chaque circuit électrique est adapté pour résister à une exposition à des différences de potentiel de l'ordre d'une quinzaine de kiloVolts (kV) pendant une minute lors des phases de validation des composants. Or, si le circuit est relié directement à la caténaire dont la tension est par exemple de 25kV/50Hz, les surtensions pouvant être vues par la caténaire impose que le circuit électrique soit capable de résister à une tension alternative de 60 kV pendant une minute. En effet, le refroidissement du dispositif électrique étant relié à la masse sur sa face arrière et au potentiel de la caténaire sur sa face avant impose de repenser l'isolation électrique du dispositif électrique.

Dans l'état de la technique, le ou les substrats isolants du circuit électrique sont usuellement réalisés en nitrure d'aluminium avec une épaisseur de l'ordre de 1 mm.

La solution la plus naturelle au problème posé est d'employer le nitrure d'aluminium avec une épaisseur plus importante que celle utilisée pour la réalisation de substrats supportant 15 kV pendant 1 minute.

Mais, la demanderesse s'est aperçue en effectuant des tests diélectriques que cela ne fonctionnait pas du fait de la variation de la rigidité diélectrique avec l'épaisseur. Ainsi, si un millimètre de nitrure d'aluminium peut supporter x kV, deux millimètres de ce même matériau ne supporte pas 2x kV mais une valeur inférieure. Autrement dit, il est observé un phénomène correspondant à une chute de la rigidité diélectrique lorsque l'épaisseur du matériau augmente.

De ce fait, la demanderesse estime que pour obtenir un substrat en nitrure d'aluminium résistant à une tension alternative de 60 kV pendant 1 minute, des épaisseurs supérieures à 10 mm sont à envisager. Mais, ces épaisseurs sont trop importantes puisqu'il en résulterait des contraintes thermomécaniques très élevées et des performances thermiques très mauvaises.

Ainsi, le nitrure d'aluminium qui est actuellement utilisé pour réaliser le substrat ne peut pas être envisagé pour une exposition de 60 kV AC pendant une minute.

Il existe donc un besoin pour un dispositif électrique permettant de supporter une exposition prolongée à une tension d'au moins 25 kV / 50 Hz avec des dimensions acceptables, en particulier pour l'industrie ferroviaire. Pour cela, l'invention propose un circuit électrique selon la revendication 1.

Suivant des modes de réalisation particuliers, le circuit comprend une ou plusieurs des caractéristiques selon les revendications 2 à 6.

L'invention se rapporte également à un dispositif électrique selon la revendication 7.

La présente invention a également pour objet un procédé de fabrication selon la revendication 8.

Il est aussi proposé l'utilisation d'un matériau isolant selon la revendication 9.

D'autres caractéristiques et avantages de l'invention apparaîtront à la lecture de la description détaillée qui suit des modes de réalisation de l'invention, donnée à titre d'exemple uniquement, et en référence aux dessins qui montrent :
- figure 1, une vue en perspective d'un exemple d'un dispositif électrique,
- figures 2 à 6, des vues schématiques de différents modes de réalisation d'un circuit électrique susceptible d'être contenu dans le dispositif, et
- figure 7, une vue en perspective du circuit de la figure 2.

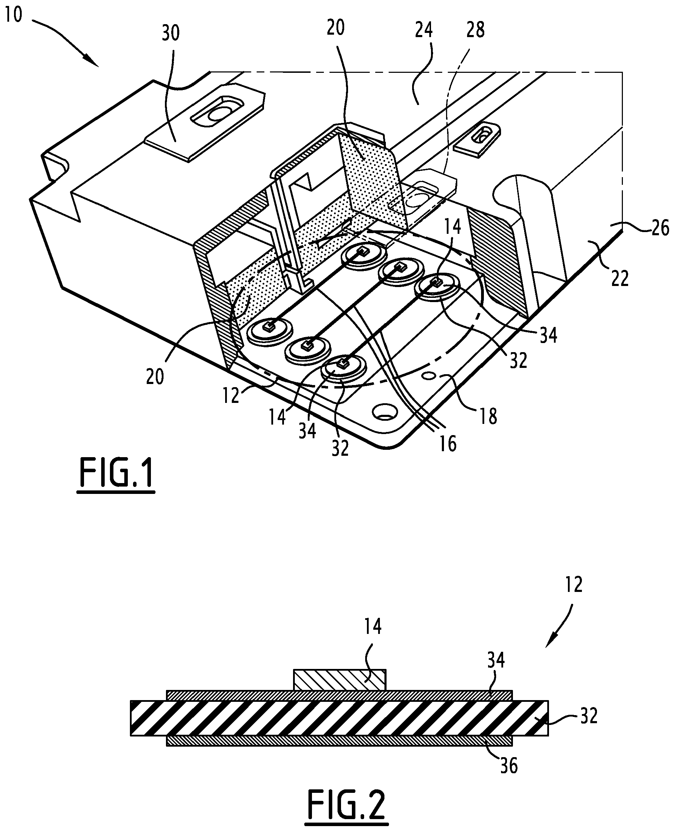

Il est proposé un dispositif 10 de protection d'un circuit électrique, tel que représenté sur la figure 1.

Dans cette figure, le dispositif 10, qui constitue un pack, est représenté schématiquement en perspective, une partie du dispositif 10 ayant été découpée pour pouvoir illustrer l'intérieur du dispositif 10. Le dispositif 10 comporte un circuit électrique 12. Ce circuit électrique 12 est un circuit utilisé dans le domaine ferroviaire. Il s'agit avantageusement d'un circuit électronique de puissance.

Le circuit 12 comporte une pluralité de circuits intégrés 14. Selon l'exemple de la figure 1, le circuit 12 comporte six circuits intégrés 14 ; seuls deux sont référencés sur la figure par commodité. Chaque circuit intégré 14 est par exemple un transistor. A titre d'illustration, des transistors bipolaires à grilles isolées (usuellement appelés sous l'acronyme IGBT qui désigne en anglais « insulated gate bipolar transistor ») ou des transistors à effets de champ (JFET pour « junction field effect transistor » ou MOSFET pour « metal oxyde semi-conductor field transistor ») peuvent être utilisés.

Les circuits intégrés 14 sont reliés électriquement entre eux selon des routages plus ou moins complexes réalisés dans des couches conductrices. Des exemples de mode de réalisation seront présentés en référence aux figures 2 à 6. Selon l'exemple de la figure 1, à titre de simplification, ces routages sont symbolisés schématiquement par les traits 16, et l'ensemble des circuits 14 est visible alors qu'en réalité, les circuits 14 sont répartis uniformément sur l'ensemble du dispositif 10.

Le dispositif 10 comporte un support 18 formant une semelle de support. Le support 18 est, par exemple, en AlSiC (particule de carbure de silicium SiC dans une matrice aluminium). Le circuit 12 est fixé sur le support 18. Le support 18 est refroidi par un dispositif de refroidissement (plaque à eau ou radiateur) non représenté permettant, par échange thermique, de limiter la température du circuit 12.

De manière à protéger le circuit électrique 12, le dispositif 10 est également muni d'une couche de protection 20 environnementale du circuit 12. Cela signifie que le circuit électrique 12 est encapsulé à l'aide d'un matériau spécifique du côté opposé au support 18 sur lequel le circuit 12 est fixé. Ce matériau est, par exemple, un gel silicone.

Le dispositif 10 est muni d'un boîtier 22 externe avec un couvercle 24 et des parois latérales 26. Le boîtier 22 sert à protéger le circuit 12 ainsi que sa couche de protection 20. A titre d'exemple, un boîtier 22 réalisé en plastique convient pour cet usage. Le boitier 22 est fixé à la semelle 18 par un procédé de collage et d'assemblage vissé.

Le dispositif 10 comporte en outre une connectique d'entrée 28 de la tension et une connectique de sortie 30 de la tension, ces connectiques 28 et 30 étant dans le boîtier 22.

A titre d'illustration, si le circuit intégré 14 est équivalent à un transistor ou à un interrupteur ayant de manière connue en soi un émetteur et un collecteur, la connectique d'entrée 28 est reliée au collecteur de chaque circuit 14 tandis que la connectique de sortie 30 est reliée à l'émetteur de chaque circuit 14 via des conducteurs.

Ainsi, dans la configuration prévue par l'invention, c'est par les conducteurs de ces connectiques que circule le courant de puissance.

Selon l'exemple de la figure 1, la connectique d'entrée 28 est dessinée en traits mixtes pour indiquer qu'elle serait effectivement visible si le boîtier 22 n'avait pas été coupé pour les besoins de la représentation.

Un exemple de mode de réalisation pour le circuit 12 est plus spécifiquement représenté à la figure 2. Dans cette figure, le circuit 12 comporte un circuit intégré 14 se présentant sous la forme d'une puce (aussi désignée par le terme « chip » en anglais).

Le circuit 12 comporte un substrat 32 constitué de d'un matériau isolant, une couche supérieure 34 et une couche inférieure 36.

Les couches 34 et 36 ont une épaisseur de l'ordre de 300 µm (microns) et sont conductrices. Elles sont par exemple obtenues par métallisation et réalisées en carbure de tungstène, en cuivre, en aluminium ou en tungstène. Dans un exemple de réalisation, la connectique d'entrée 28 est reliée à la couche supérieure 34, et la connectique de sortie 30 est reliée à la couche inférieure 36.

La couche supérieure 34 présente des pistes électriques définissant un circuit électrique 12 permettant de réaliser la fonction interrupteur grâce à l'utilisation d'un ou plusieurs circuits intégrés 14.

La couche inférieure 36 est une métallisation pleine qui permet de fixer le substrat 32 sur le support 18. Le procédé de fixation peut être un procédé par brasage ou tout autre procédé de fixation connu. Le support 18 est ainsi fixé au refroidisseur (typiquement une plaque à eau ou un radiateur) qui est connecté électriquement à la masse du train.

Le substrat 32 est ainsi soumis au potentiel de la tension continue entre sa couche supérieure 34 et la masse qui est connectée de manière indirecte à la couche inférieure 36. Le substrat 32 peut ainsi être exposé à des tensions très importantes. Dans le cadre de la configuration métallisée de cette invention illustrée à titre d'exemple, il est désiré que le substrat 32 puisse résister à une exposition d'une tension alternative de 60 kV efficace pendant une minute.

La demanderesse, en plus des tests déjà mentionnés concernant un substrat réalisé en nitrure d'aluminium, a effectué des tests sur de nombreux matériaux. Ainsi, elle a pu montrer que, de manière surprenante, un substrat réalisé en diamant ou en nitrure de bore cubique avec une proportion supérieure à 90% ne supporte pas une exposition prolongée à une tension d'au moins 50 kV avec des dimensions acceptables.

Dans le cadre de cette invention, une composition spécifique pour le matériau du substrat 32 permet de répondre à cet impératif. Le matériau proposé comprend en poids : de 25 à 70% de nitrure de bore sous la forme cubique, de 25 à 75% de nitrure d'aluminium et de 0 à 5% d'éléments de frittage. D'autres composés peuvent être présents.

De préférence, le matériau du substrat 32 consiste en une répartition en poids de 25 à 70% du nitrure de bore sous forme cubique, de 25 à 75% de nitrure d'aluminium et de 0 à 5% d'éléments de frittage.

Les éléments de frittage permettent d'augmenter la conductivité thermique du matériau, néanmoins ils ne sont pas obligatoires, c'est-à-dire que la quantité des éléments de frittage peut être égale à 0%. Par exemple, le matériau du substrat 32 présente une conductivité thermique supérieure à 50 W/(m.K), de préférence 100 W/(m.K).

Dans un exemple de réalisation, les éléments de frittage comprennent ou sont constitués d'oxyde d'yttrium de formule chimique Y₂O₃, d'un nitrure, d'un oxyde tel l'oxyde de calcium de formule chimique CaO. En variante, le matériau comprend ou est également constitué d'un mélange de deux ou plusieurs des éléments précités.

De préférence, le matériau du substrat est composé de 25 à 70% en poids de nitrure de bore sous forme cubique.

De préférence, le matériau est composé de 25 à 75% en poids de nitrure d'aluminium.

Selon une composition préférée, le matériau comporte en poids 35% de nitrure de bore cubique et 65% de nitrure d'aluminium.

Il a été montré expérimentalement, que pour un substrat d'une épaisseur de 5 mm dans la composition indiquée, il est possible de résister à une exposition continue de 60 kV AC pendant une minute.

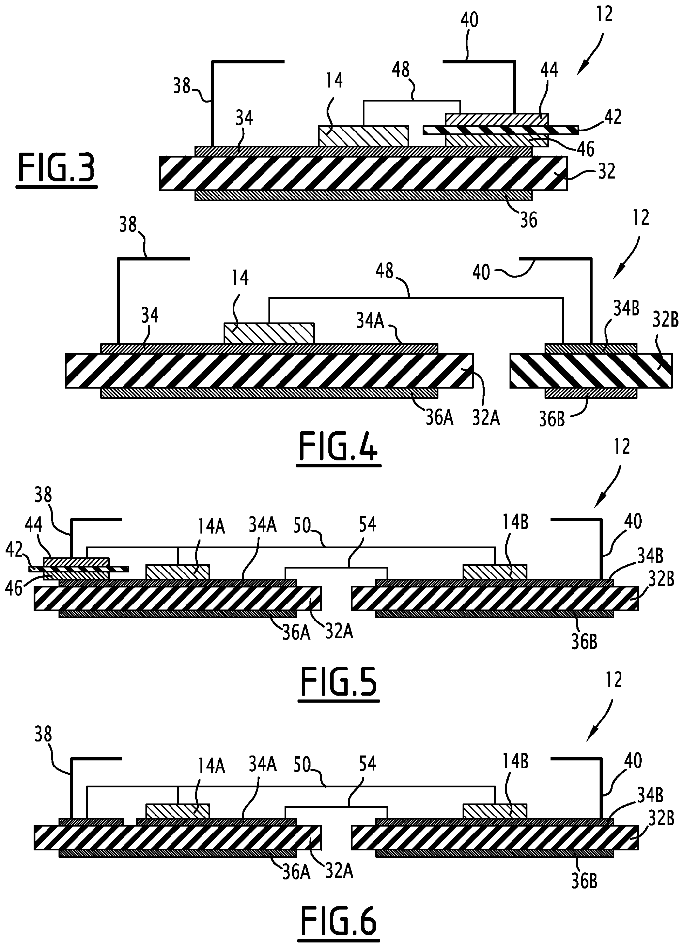

De ce fait, contrairement à l'état de la technique qui imposerait d'utiliser une épaisseur de matériau supérieure à 10 mm ou d'utiliser des circuits de refroidissement avec un liquide diélectrique comme liquide de refroidissement, les circuits de refroidissement traditionnels utilisant de l'eau glycolée peuvent être conservés dans le cadre de l'invention présentée. Des configurations alternatives sont possibles pour le circuit 12 ainsi que cela est illustré par les figures 3 à 6.

La figure 3 montre un circuit 12 dans une configuration de routage de type vertical. L'intérêt du routage vertical est de permettre d'obtenir des circuits électriques avec un encombrement réduit et d'éviter un routage de la couche supérieure 34 dans le cas d'un matériau conducteur électrique extrêmement dur de type carbure de tungstène. De plus, il permet d'avoir une configuration symétrique et un champ électrique constant sur toute la périphérie de la couche supérieure 34. En effet, la couche supérieure 34 est conductrice sur toute sa surface et sans discontinuité. Cela évite aussi d'induire des contraintes électriques supplémentaires lors des commutations de puissance. De même que pour la figure 2, le circuit 12 comporte un circuit intégré 14 sous la forme d'une puce, un substrat 32 constitué d'un matériau isolant, et deux couches conductrices 34 et 36.

La couche 34 est reliée à un premier conducteur 38 qui est relié à la connectique d'entrée 28 non représentée sur la figure 3. En variante, le premier conducteur 38 correspond à la connectique d'entrée 28. Ainsi, le premier conducteur 38 peut correspondre à un collecteur.

Le circuit 12 comporte également un second conducteur 40 qui est relié à la connectique de sortie 30 non représentée sur la figure 3. En variante, le second conducteur 40 correspond à la connectique de sortie 30. Ainsi, le second conducteur 40 peut correspondre à un émetteur.

Le circuit 12 comporte également un deuxième substrat 42 constitué d'un matériau isolant de type connu entouré par deux métallisations 44 et 46. Ce deuxième substrat 42 est qualifié de « substrat supérieur » du fait qu'il est positionné sur la couche supérieure 34. Ce deuxième substrat 42 et ses métallisations 44 et 46, cet ensemble étant appelé également « substrat 42 métallisé », sont placés sur la couche supérieure 34 de manière à être en contact électrique avec le circuit intégré 14 via une liaison 48 et avec la connectique de sortie 30 via le second conducteur 40.

Il apparaît ainsi que ce deuxième substrat 42 n'est pas soumis aux mêmes contraintes de différences de potentiels que le substrat 32. Le deuxième substrat 42 peut donc être plus fin que le substrat 32, ce qui est illustré schématiquement sur la figure 3. En outre, le second substrat 42 peut également être fait en un matériau de nature différente comme du nitrure d'aluminium. La fonction principale du deuxième substrat 42 est d'éviter un routage de la couche supérieure 34.

Un mode de réalisation alternatif au mode de réalisation de la figure 3 est celui de la figure 4.

Les références identiques ne sont pas répétées dans ce cas qui illustre, au lieu d'un routage vertical, un routage de type plan-plan. En effet, le second conducteur 40 n'est plus connecté à un « substrat supérieur » comme dans la figure 3 mais plutôt à un substrat 32B déporté, via sa couche supérieure 34B, qui présente la même épaisseur que le substrat 32A initial.

La figure 3 correspond à un dispositif 10 comportant un circuit 12 seul de type interrupteur sur un même substrat. Dans le cas de la figure 4, les matériaux isolants des substrats 32A et 32B sont identiques, les deux matériaux étant soumis sensiblement aux mêmes contraintes électriques.

Les modes de réalisation des figures 5 et 6 correspondent au cas où on utilise le dispositif 10 avec un courant plus important. Cela implique de paralléliser des circuits 14, dont le nombre peut varier de deux à plus de dix, pour obtenir le courant souhaité. Ainsi, dans les configurations représentées en figures 5 et 6, sont utilisés deux circuits intégrés 14A et 14B au lieu d'un seul comme c'est le cas pour les exemples illustrés sur les figures 3 et 4.

Dans d'autres exemples non représentés, au lieu de deux circuits intégrés 14A et 14B, sont utilisés un nombre entier supérieur ou égal à trois circuits intégrés 14.

Selon l'exemple de la figure 5, le substrat 32A qui est un substrat déporté similaire à celui de la figure 4 comporte sur sa couche supérieure 34A un circuit intégré 14A ainsi qu'un « substrat 42 métallisé » double face tel que décrit à la figure 3. Le circuit intégré 14B qui est supporté par le substrat 32B est relié au circuit intégré 14A du substrat 32A via une connexion 50. Cette connexion 50 est reliée également à la métallisation 44 du substrat 42, cette métallisation étant connecté au premier conducteur 38. Le circuit intégré 14B est relié à la couche conductrice 34B elle-même reliée à la connectique 40. En outre, un pont de connexion 54 est réalisé entre la couche supérieure 34A du substrat 32A et la couche supérieure 34B du substrat 32B.

Selon un mode de réalisation alternatif illustré par la figure 6, au lieu d'utiliser un «substrat 42 métallisé» supplémentaire, il peut être simplement pratiqué une interruption de la couche 34A conductrice dans le cas d'une métallisation molle de type cuivre ou aluminium, ce qui est plus simple à réaliser et présente un encombrement moins important.

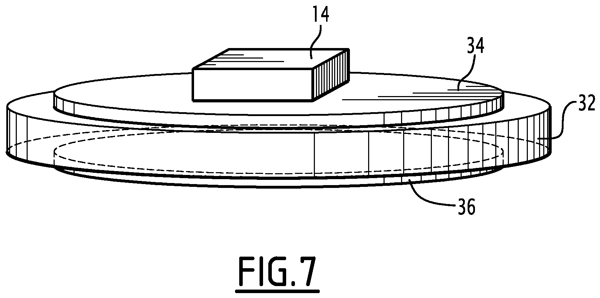

La figure 7 illustre une vue en perspective du substrat de la figure 2. Le substrat 32 est un cylindre droit dont la courbe directrice est un cercle. Les couches 34 et 36 conductrices ont la même forme. Une telle forme permet de symétriser la contrainte appliquée au circuit 12, le rendant plus résistant. En variante, le substrat 32 est un prisme droit ayant des couches 34, 36 de la forme soit d'un cylindre droit dont la courbe directrice est un cercle soit d'un prisme droit.

Dans tous les modes de réalisation, le circuit 12 est adapté à supporter une différence de potentiel de 60 kV / 50 Hz entre les couches du substrat 32 d'isolation pendant une minute. Cela rend le circuit 12 particulièrement adapté aux contraintes d'un branchement direct au potentiel de la caténaire, et notamment d'une caténaire délivrant une tension supérieure à 14 kV efficace.

## Revendications

1. Un circuit (12) électrique comportant :
- au moins un circuit intégré (14 ; 14A, 14B),
- au moins un substrat (32 ; 32A, 32B), constitué d'un matériau isolant, présentant deux couches (34, 36) conductrices, le substrat (32 ; 32A, 32B) ayant une épaisseur inférieure à 7 mm, de préférence 5 mm, le substrat (32 ; 32A, 32B) ayant, en outre, une composition spécifique de manière à ce que le substrat (32 ; 32A, 32B) supporte une différence de potentiel d'au moins 50 kV alternatif entre les deux couches (34, 36) conductrices, une des couches (34, 36) étant reliée à au moins un circuit intégré (14 ; 14A, 14B),
le matériau isolant étant dans un matériau comprenant en poids :
- entre 25 et 70% de nitrure de bore sous la forme cubique,
- entre 25 et 75% de nitrure d'aluminium et
- entre 0 et 5% d'éléments de frittage.

2. Le circuit (12) selon la revendication 1, dans lequel le matériau du substrat (32 ; 32A, 32B) comporte en poids 35% de nitrure de bore cubique et 65% de nitrure d'aluminium.

3. Le circuit selon la revendication 1 ou 2, dans lequel l'élément de frittage du matériau du substrat (32 ; 32A, 32B) comprend ou est constitué d'oxyde d'yttrium, ou d'un nitrure, ou d'un oxyde, ou d'un oxyde de calcium ou l'un quelconque de leurs mélanges.

4. Le circuit selon l'une quelconque des revendications 1 à 3, dans lequel le matériau du substrat (32 ; 32A, 32B) est capable de supporter une exposition continue à une différence de potentiel de 60 kV alternatif ou 90kV continue appliquée entre deux connectiques (28, 30) pendant une minute.

5. Le circuit selon l'une quelconque des revendications 1 à 4, dans lequel le substrat (32 ; 32A, 32B) a une forme de cylindre droit ou de prisme droit.

6. Le circuit selon l'une quelconque des revendications 1 à 5, dans lequel le matériau du substrat (32 ; 32A, 32B) présente une conductivité thermique supérieure à 50 W/(m.K), de préférence 100 W/(m.K).

7. Un dispositif (10) électrique pouvant être relié directement à une caténaire dont la tension est supérieure à 14 kV efficace comportant :
- un circuit (12) selon l'une quelconque des revendications 1 à 6, et
- un boîtier (22) de protection entourant le circuit (12).

8. Un procédé de fabrication d'un circuit (12) selon l'une quelconque des revendications 1 à 6 comportant :
- la fourniture d'au moins un circuit intégré (14 ; 14A, 14B);
- la connexion des au moins un circuit intégré (14 ; 14A, 14B) à une des couches d'au moins un substrat (32 ; 32A, 32B) d'isolation présentant deux couches (34, 36) conductrices, le substrat (32 ; 32A, 32B) ayant une épaisseur inférieure à 7 mm, de préférence 5 mm, le substrat (32 ; 32A, 32B) ayant, en outre, une composition spécifique de manière à ce que le substrat (32 ; 32A, 32B) supporte une différence de potentiel d'au moins 50 kV alternatif entre les deux couches (34, 36) conductrices, le au moins un substrat (32 ; 32A, 32B) isolant étant dans un matériau comprenant en poids :
- entre 25 et 70% de nitrure de bore sous la forme cubique,
- entre 25 et 75% de nitrure d'aluminium et
- entre 0 et 5% d'éléments de frittage.

9. Utilisation d'un matériau isolant comprenant en poids :
- entre 25 et 70% de nitrure de bore sous la forme cubique,
- entre 25 et 75% de nitrure d'aluminium, et
- entre 0 et 5% d'éléments de frittage
pour la fabrication d'un substrat (32 ; 32A, 32B) d'isolation de forme circulaire ou parallélépipédique présentant deux couches (34, 36) conductrices, le substrat (32 ; 32A, 32B) ayant une épaisseur inférieure à 7 mm, de préférence 5 mm, le substrat (32 ; 32A, 32B) ayant, en outre, une composition spécifique de manière à ce que le substrat (32 ; 32A, 32B) supporte une différence de potentiel d'au moins 50 kV alternatif entre les deux couches (34, 36) conductrices.

## Patentansprüche

1. Elektrischer Schaltkreis (12), aufweisend:
- wenigstens einen integrierten Schaltkreis (14; 14A, 14B),
- wenigstens ein Substrat (32; 32A, 32B), das von einem isolierenden Material gebildet ist und zwei leitende Schichten (34, 36) hat, wobei das Substrat (32; 32A, 32B) eine Dicke von kleiner als 7 mm, bevorzugt 5 mm, hat, wobei das Substrat (32; 32A, 32B) ferner aufweist eine spezifische Zusammensetzung, sodass das Substrat (32; 32A, 32B) eine Spannungsdifferenz von wenigstens 50kV wechselnd zwischen den beiden leitenden Schichten (34, 36) erträgt, wobei eine der Schichten (34, 36) mit wenigstens einem integrierten Schaltkreis (14; 14A, 14B) verbunden ist,
wobei das isolierende Material aus einem Material ist, das aufweist in Gewicht:
- zwischen 25 und 70% Bornitrit in kubischer Form,
- zwischen 25 und 75% Aluminiumnitrit und
- zwischen 0 und 5% Sinterelemente.

2. Schaltkreis (12) gemäß Anspruch 1, wobei das Material des Substrats (32; 32A, 32B) aufweist in Gewicht 35% kubisches Bornitrit und 65% Aluminiumnitrit.

3. Schaltkreis gemäß Anspruch 1 oder 2, wobei das Sinterelement des Materials des Substrats (32; 32A, 32B) aufweist oder gebildet ist von Yttriumoxyd oder von einem Nitrit oder von einem Oxyd oder von einem Kalziumoxyd oder irgendeiner von deren Mischungen.

4. Schaltkreis gemäß irgendeinem der vorhergehenden Ansprüche, 1-3, wobei das Material des Substrats (32; 32A, 32B) imstande ist, eine kontinuierliche Belastung mit einer Spannungsdifferenz von 60kV wechselnd oder 90kV gleichförmig erträgt, die zwischen zwei Anschlüssen (28, 30) während einer Minute aufgebracht wird.

5. Schaltkreis gemäß irgendeinem der Ansprüche 1 bis 4, wobei das Substrat (32; 32A, 32B) eine Form eines Geradezylinders oder eines Geradeprismas hat.

6. Schaltkreis gemäß irgendeinem der Ansprüche 1 bis 5, wobei das Material des Substrats (32; 32A, 32B) eine thermische Leitfähigkeit hat, die größer als 50 W/(m.K), bevorzugt 100 W/(m.K), ist.

7. Elektrische Vorrichtung (10), die direkt mit einer Oberleitung verbunden werden kann, deren Spannung größer als 14 kV effektiv ist, aufweisend:
- einen Schaltkreis (12) gemäß irgendeinem der Ansprüche 1 bis 6, und
- eine Schutz-Gehäuse (22), welches den Schaltkreis (12) umgibt.

8. Verfahren zur Herstellung eines Schaltkreises (12) gemäß irgendeinem der Ansprüche 1 bis 6, aufweisend:
- das Bereitstellen wenigstens eines integrierten Schaltkreises (14; 14A, 14B),
- das Verbinden des wenigstens einen integrierten Schaltkreises (14; 14A, 14B) mit einer der Schichten wenigstens eines Isolations-Substrats (32; 32A, 32B), das zwei leitende Schichten (34, 36) hat, wobei das Substrat (32; 32A, 32B) eine Dicke von kleiner als 7 mm, bevorzugt 5 mm, hat, wobei das Substrat (32; 32A, 32B) ferner eine spezifische Zusammensetzung hat, sodass das Substrat (32; 32A, 32B) eine Spannungsdifferenz von wenigstens 50 kV wechselnd hat zwischen den beiden leitenden Schichten (34, 36), wobei das wenigstens eine isolierende Substrat (32; 32A, 32B) aus einem Material ist, das aufweist in Gewicht:
- zwischen 25 und 70% Bornitrit in kubischer Form,
- zwischen 25 und 75% Aluminiumnitrit und
- zwischen 0 und 5% Sinterelemente.

9. Verwendung eines isolierenden Materials, das aufweist in Gewicht:
- zwischen 25 und 70% Bornitrit in kubischer Form,
- zwischen 25 und 75% Aluminiumnitrit und
- zwischen 0 und 5% Sinterelemente
für die Herstellung eines Isolations-Substrats (32; 32A, 32B) von kreisförmiger oder quaderförmiger Gestalt, das zwei leitende Schichten (34, 36) hat, wobei das Substrat (32; 32A, 32B) eine Dicke von kleiner als 7 mm, bevorzugt 5 mm, hat, wobei das Substrat (32; 32A, 32B) ferner eine spezifische Zusammensetzung hat, sodass das Substrat (32; 32A, 32B) eine Spannungsdifferenz von wenigstens 50kV alternierend erträgt zwischen den beiden leitenden Schichten (34, 36).

## Claims

1. An electrical circuit (12) comprising:
- at least one integrated circuit (14; 14A, 14B),
- at least one substrate (32; 32A, 32B) formed from an insulating material, having two conductive layers (34, 36), the substrate (32; 32A, 32B) having a thickness less than 7 mm, preferably 5 mm, the substrate (32; 32A, 32B) having, furthermore, a specific composition such that the substrate (32; 32A, 32B) supports an alternating potential difference of at least 50 kV between the two conductive layers (34, 36), one of the layers (34, 36) being connected to at least one integrated circuit (14; 14A, 14B),
the insulating material being in a material comprising by weight:
- between 25 and 70% of boron nitride in cubic form,
- between 25 and 75% of aluminium nitride, and
- between 0 and 5% of sintering elements.

2. The circuit (12) according to claim 1, in which the material of the substrate (32; 32A, 32B) comprises by weight 35% of cubic boron nitride and 65% of aluminium nitride.

3. The circuit according to claim 1 or 2, in which the sintering element of the material of the substrate (32; 32A, 32B) comprises or is formed from yttrium oxide, or a nitride, or an oxide, or a calcium oxide or any of their mixtures.

4. The circuit according to any of claims 1 to 3, in which the material of the substrate (32; 32A, 32B) is capable of supporting continuous exposure to an alternating potential difference of 60 kV or continuous potential difference of 90 kV applied between two connections (28, 30) for one minute.

5. The circuit according to any of claims 1 to 4, in which the substrate (32; 32A, 32B) has a straight cylindrical form or straight prismatic form.

6. The circuit according to any of claims 1 to 5, in which the material of the substrate (32; 32A, 32B) has a thermal conductivity greater than 50 W/(m.K), preferably 100 W/(m.K).

7. An electrical device (10) which is able to be connected directly to a catenary, the voltage of which is greater than 14 kV comprising:
- a circuit (12) according to any of claims 1 to 6, and
- a protective casing (22) surrounding the circuit (12).

8. A method for manufacturing a circuit (12) according to any of claims 1 to 6 comprising:
- provision of at least one integrated circuit (14; 14A, 14B);
- connection of the at least one integrated circuit (14; 14A, 14B) to one of the layers of at least one insulating substrate (32; 32A, 32B) having two conductive layers (34, 36), the substrate (32; 32A, 32B) having a thickness less than 7 mm, preferably 5 mm, the substrate (32; 32A, 32B) having, furthermore, a specific composition such that the substrate (32; 32A, 32B) supports an alternating potential difference of at least 50 kV between the two conductive layers (34, 36), the at least one insulating substrate (32; 32A, 32B) being in a material comprising by weight:
- between 25 and 70% of boron nitride in cubic form,
- between 25 and 75% of aluminium nitride, and
- between 0 and 5% of sintering elements.

9. Use of an insulating material comprising by weight:
- between 25 and 70% of boron nitride in cubic form,
- between 25 and 75% of aluminium nitride, and
- between 0 and 5% of sintering elements
for manufacture of an insulating substrate (32; 32A, 32B) of circular or parallelepipedic form having two conductive layers (34, 36), the substrate (32; 32A, 32B) having a thickness less than 7 mm, preferably 5 mm, the substrate (32; 32A, 32B) having, furthermore, a specific composition such that the substrate (32; 32A, 32B) supports an alternating potential difference of at least 50 kV between the two conductive layers (34, 36).
